# EUROPÄISCHE PATENTANMELDUNG

(11) **EP 1 041 626 A2**
(43) Veröffentlichungstag der Anmeldung: **04.10.2000**
(21) Anmeldenummer: 00105786.8
(22) Anmeldetag: 18.03.2000
(51) Int. Cl.: H01L 23/13, H01L 25/07

(54) **Halbleitermodul**

(30) Priorität: 31.03.1999 DE 19914815
(71) Anmelder: ABB RESEARCH LTD., 8050 Zürich (CH)
(72) Erfinder: Stuck, Alexander Dr., 5430 Wettingen (DE); Steimer, Peter Dr, 5434 Unterehrendingen (CH); Zeller, Hansruedi Dr., 5242 Birr (CH); Zehringer, Raymond Dr., 4132 Muttenz (CH)
(74) Vertreter: ABB Patent Attorneys

(57) **Zusammenfassung**

Bei einem Halbleitermodul mit einem Basiselement (2), mindestens einem auf dem Basiselement (2) angeordneten Isolationselement (3), welches auf zwei gegenüberliegenden Seiten mit einer Metallschicht (4,5) versehen ist, und mit mindestens einem auf dem Isolationselement (3) angeordneten Halbleiterelement (6) ist mindestens eine der Metallschichten (4,5) gewölbt ausgebildet. Dadurch lassen sich Feldüberhöhungen in den Randzonen minimieren und die Spannungsfestigkeit des Halbleitermoduls erhöhen.

## Beschreibung

### Technisches Gebiet

Die Erfindung bezieht sich auf das Gebiet der Leistungselektronik. Sie bezieht sich auf ein Halbleitermodul gemäss Oberbegriff des Patentanspruches 1.

### Stand der Technik

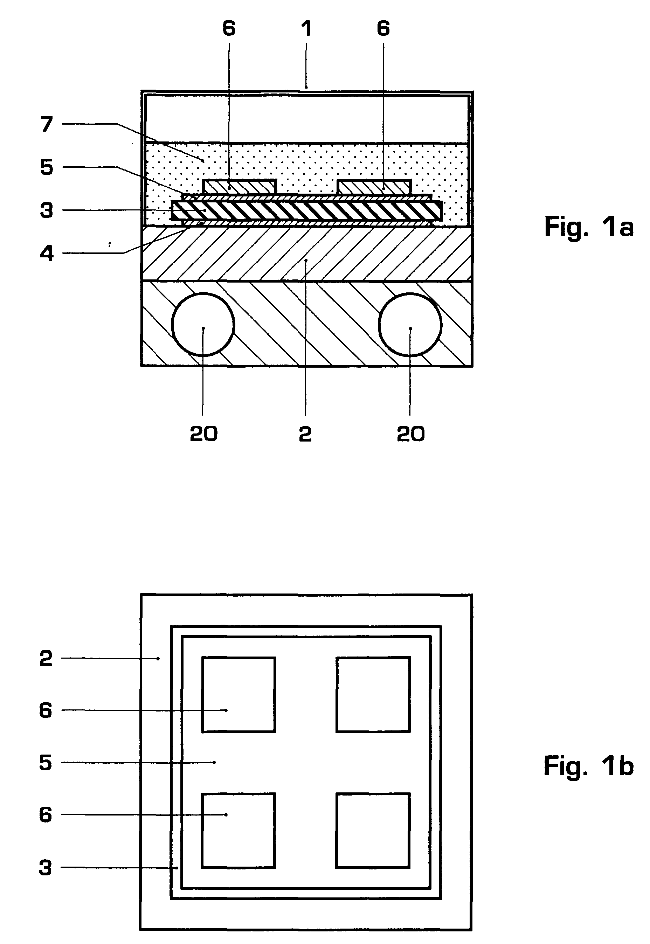

Ein derartiges Halbleitermodul ist beispielsweise aus R. Zehringer et al., Materials Research Society Symposium Proceedings, Volume 483, Power Semiconductor Materials and Devices, 1998, S. 369-380, bekannt. Diese Publikation beschreibt, wie in der beiliegenden Figur 1 dargestellt ist, ein Halbleitermodul mit einem Modulgehäuse 1, einer metallenen Basisplatte 2 und mehreren darauf angeordneten, vom Modulgehäuse überdeckten Halbleiterelementen 6, in diesem Fall IGBT-Chips (Insulated Gate Bipolar Transistor) und Dioden. Das Modulgehäuse ist im allgemeinen mit einer Gelmasse 7 ausgefüllt, welche als elektrische Isolationsschicht und als Korrosionsschutz dient sowie auf Verbindungsdrähte wirkende Zugkräfte vermindert.

Die Basisplatte ist mit einer Wasserkühlung 20 verbunden, um die von den Halbleiterelementen erzeugte Wärme abzuführen. Auf der Basisplatte ist ein Substrat in Form einer metallbeschichteten Keramikplatte 3 angeordnet. Sie bildet eine elektrische Isolation zwischen Halbleiterelemente und Basisplatte beziehungsweise Wasserkühlung und weist zudem eine gute Wärmeleitfähigkeit auf, um die Wärme der Halbleiterelemente zur Basisplatte abzuführen. Basisplatte, Keramikplatte und Halbleiterelemente sind aufeinander gelötet, wobei die Metallschichten 4,5 der Keramikplatte die Lötverbindung ermöglichen.

Gute Wärmeleitfähigkeit und schlechte elektrische Leitfähigkeit lassen sich heute in Materialien kombinieren, so dass es keine Schwierigkeiten bereitet, relativ dünne, jedoch gut wärmeleitende Isolationselemente, beispielsweise aus Aluminiumnitrid (AlN), mit einer guten elektrischen Isolierfähigkeit herzustellen. So reicht theoretisch eine Dicke von 1.5 bis 2 mm aus, um 20kV zu isolieren.

Randeffekte, insbesondere verursacht durch Kanten und Ecken der Metallschichten, wirken sich jedoch nachteilig auf die Spannungsfestigkeit des Halbleitermoduls aus, insbesondere bei Hochleistungshalbleitermodulen oberhalb von 1200 V. Kanten und Ecken der Metallschichten weisen ein inhomogenes, verstärktes elektrisches Feld auf. Diese Feldüberhöhung führt zu Teilentladungen und begrenzt die Spannungsfestigkeit des gesamten Aufbaus. Dabei verhält sich die Feldstärke an den Rändern mindestens quadratisch zur Spannung, so dass zur Vermeidung derartiger Teilentladungen eine massiv dickere elektrische Isolierung notwendig wäre. Luftbläschen, welche beim Einfüllen von Gel in das Modulgehäuse gerade in den Randzonen entstehen können, begünstigen Teilentladungen und bilden einen zusätzlichen kritischen Faktor bezüglich der Funktionsfähigkeit des Halbleitermoduls.

### Darstellung der Erfindung

Es ist deshalb Aufgabe der Erfindung, ein Halbleitermodul der eingangs genannten Art zu schaffen, welches eine verbesserte Spannungsfestigkeit aufweist.

Diese Aufgabe löst ein Halbleitermodul mit den Merkmalen des Patentanspruches 1.

Beim erfindungsgemässen Halbleitermodul ist mindestens eine der Metallschichten gewölbt ausgebildet, wodurch auch in Randbereichen ein möglichst homogenes elektrisches Feld erhalten wird und Feldüberhöhungen minimiert werden.

In einer ersten Ausführungsform ist mindestens eine der Metallschichten wannenförmig gewölbt, wobei der Abstand zu einer auf der gegenüberliegenden Seite des Isolationselementes angeordneten zweiten Metallschicht zu den Rändern hin zunimmt, wodurch eine Feldüberhöhung im Randbereich reduziert wird.

In einer zweiten Ausführungsform wird die Wölbung durch wulstförmige Abschlüsse, vorzugsweise mit rundem Querschnitt, an Ecken und/oder Kanten gebildet. In einer bevorzugten Variante weist das Isolationselement Vertiefungen zur Aufnahme mindestens der vorstehenden Wülste auf. Ist die gesamte Metallschicht in das Isolationselement eingelassen, so dass es mit diesem eine plane Oberfläche bildet, lässt sich beim Auffüllen mit Gel die Bildung von Luftbläschen vermeiden, da schwer zugängliche kleine Hohlräume vermieden werden.

Weitere vorteilhafte Ausführungsformen gehen aus den abhängigen Patentansprüchen hervor.

### Kurze Beschreibung der Zeichnungen

Im folgenden wird der Erfindungsgegenstand anhand von bevorzugten Ausführungsbeispielen, welche in den beiliegenden Zeichnungen dargestellt sind, näher erläutert. Es zeigen:
- Figur 1a: einen Querschnitt durch ein schematisch dargestelltes Halbleitermodul inklusive Gehäuse gemäss dem Stand der Technik;
- Figur 1b: eine Aufsicht des Halbleitermoduls gemäss Figur 1a ohne Gehäuse;
- Figur 2: einen Querschnitt durch eine erste Ausführungsform eines erfindungsgemässen Halbleitermoduls;
- Figur 3: einen Querschnitt durch ein Isolationselement gemäss einer zweiten Ausführungsform des erfindungsgemässen Halbleitermoduls und
- Figur 4: einen Querschnitt durch ein Isolationselement gemäss einer dritten Ausführungsform.

### Wege zur Ausführung der Erfindung

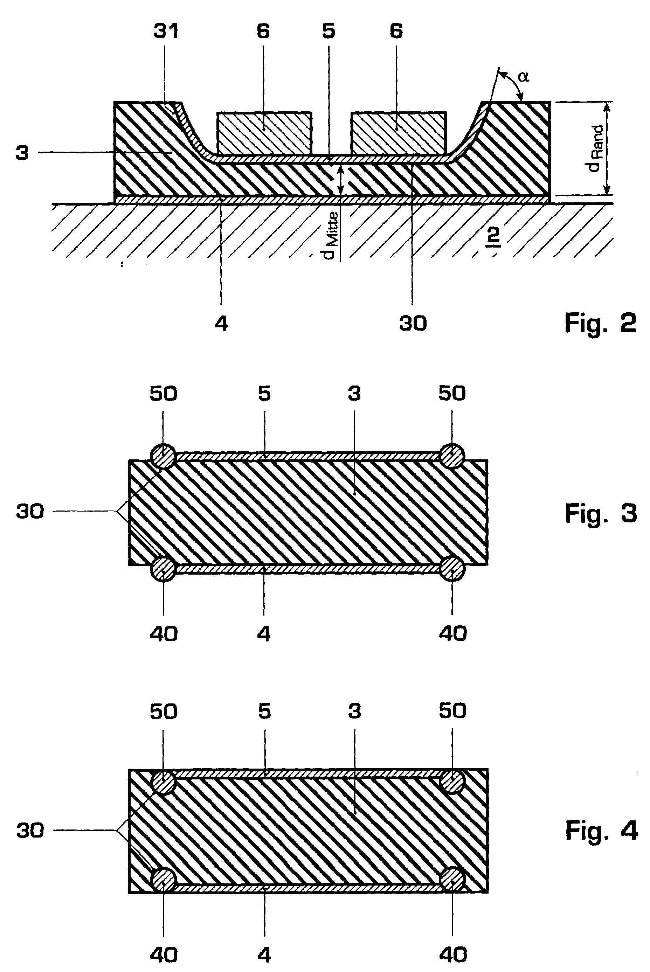

In Figur 2 ist ein erstes Ausführungsbeispiel eines erfindungsgemässen Halbleitermoduls dargestellt. Es besteht im wesentlichen aus einem Basis- oder Kühlelement 2, mindestens einem Chip oder Halbleiterelement 6 und mindestens einem zweiseitig metallbeschichteten Substrat oder Isolationselement 3. Aufgrund des stark vergrösserten Massstabes sind das Basis- und das Halbleiterelement 2,6 und ein zweites Isolationselement 3' lediglich teilweise dargestellt.

Das Isolationselement 3, im allgemeinen eine Keramikplatte, weist auf einer, vorzugsweise wie hier dargestellt auf der den Halbleiterelementen 6 zugewandten Seite, eine Vertiefung 30 auf. Diese Vertiefung 30 ist wannenförmig ausgebildet, wobei mindestens zwei, vorzugsweise alle Seiten hochgezogen sind. Dabei ist sie in der Mittelzone flach und weist steile seitliche Flanken 31 auf. Typischerweise beträgt die Tiefe der Wanne mindestens die Hälfte der Dicke des Isolationselementes 3 und die Flanken 31 schliessen mit der Oberfläche des Isolationselementes 3 einen Winkel α von mindestens 30° ein. In der Vertiefung 30 ist eine erste Metallschicht 5 vorhanden, welche sich über die seitlichen Flanken 31 erstreckt. Die Innenfläche der wannenförmigen Vertiefung bildet eine Äquipotentialfläche, wobei es hierfür nicht zwingend notwendig ist, dass die gesamte Innenfläche mit einem durch Löten oder DCB (direct copper bonding) aufgebrachten Kupferblech beschichtet ist. Es reicht im allgemeinen aus, wenn lediglich der plane Teil der wannenförmigen Vertiefung derartig metallbeschichtet wird, wobei die Schichtdicke vorzugsweise 0.1 bis 0.3 mm beträgt. Die Flanken 31 können mit einer aufgedampften Metallschicht oder einer anderen, auch eine geringe elektrische Leitfähigkeit aufweisenden Schicht versehen sein.

Die gegenüberliegende, dem Basiselement 2 zugewandte Seite des Isolationselementes 3 ist vorzugsweise planar ausgebildet und mit einer planen zweiten Metallschicht 4 versehen. Wie in Figur 2 sichtbar ist, nimmt der Abstand zwischen den zwei Metallschichten zu deren Rändern hin zu, wobei der Abstand d_{Rand} der Ränder ein Vielfaches des Abstandes d_{Mitte} der Mittelzonen beträgt. Typische Werte sind für d_{Rand} 1 - 2 mm und für d_{Mitte} 3 - 5 mm. Durch den erhöhten Abstand wird die in den Randgebieten entstehbare Feldüberhöhung reduziert.

Figur 3 zeigt eine zweite Ausführungsform gemäss der Erfindung. In diesem Fall ist das Isolationselement 3 im wesentlichen planparallel ausgebildet und mit zwei im wesentlichen planen, einander gegenüberliegenden Metallschichten 4, 5 versehen, welche an ihren Ecken und/oder Rändern Wölbungen in Form von wulstförmigen Abschlüssen 40,50 aufweisen. Diese wulstförmigen Abschlüsse 40,50 weisen vorzugsweise einen runden Querschnitt auf und haben einen Durchmesser, welcher ein Vielfaches der Dicke der Metallschicht beträgt. Typische Werte liegen bei 0.2 - 0.3 mm für die Metallschichtdicke und 1 - 4 mm für den Durchmesser der Wulst. Die wulstförmigen Abschlüsse 40,50 entschärfen die Ecken beziehungsweise Kanten und reduzieren somit ebenfalls die Feldüberhöhung.

Im hier dargestellten Ausführungsbeispiel liegen die Metallschichten 4,5 auf der planen Oberfläche des Isolationselementes 3 auf, wobei lediglich die wulstförmigen Abschlüsse 40,50 in Vertiefungen 30 aufgenommen sind.

Im Ausführungsbeispiel gemäss Figur 4 hingegen sind die Metallschichten 4,5 vollständig in eine entsprechend geformte Vertiefung des Isolationselementes 3 eingelassen, wobei sie mit diesem eine gemeinsame plane Oberfläche bilden.

Das erfindungsgemässe Halbleitermodul mit den gewölbten Metallisierungen der Isolationselemente führt zu einer Reduktion der Feldüberhöhungen und erhöht dank einer erhöhten Isolierfähigkeit den Leistungsbereich von Halbleitermodulen.

### Bezugszeichenliste

- 1: Modulgehäuse
- 2: Basiselement
- 20: Wasserkühlung
- 3,3': Isolationselement
- 30: Vertiefung
- 31: seitliche Flanke
- 4: zweite Metallschicht
- 40: wulstförmiger Abschluss
- 5: erste Metallschicht
- 50: wulstförmiger Abschluss
- 6: Halbleiterelement
- 7: Gel
- d_{Rand}: Abstand der Ränder
- d_{Mitte}: Abstand der Mittelzonen
- α: Winkel zwischen Flanke und Wannenboden

## Patentansprüche

1. Halbleitermodul mit einem Basiselement (2), mindestens einem auf dem Basiselement (2) angeordneten Isolationselement (3), welches auf zwei gegenüberliegenden Seiten mit einer Metallschicht (4,5) versehen ist, und mit mindestens einem auf dem Isolationselement (3) angeordneten Halbleiterelement (6),
dadurch gekennzeichnet,
dass mindestens eine der Metallschichten (4,5) gewölbt ausgebildet ist.

2. Halbleitermodul nach Anspruch 1, dadurch gekennzeichnet, dass das Isolationselement (3) mindestens eine Vertiefung (30) zur Aufnahme einer Wölbung der Metallschicht (4,5) aufweist.

3. Halbleitermodul nach Anspruch 1, dadurch gekennzeichnet, dass die gewölbte Metallschicht (4) wannenförmig ausgebildet ist und dass der Abstand zwischen den zwei Metallschichten (4,5) zu deren Rändern hin zunimmt.

4. Halbleitermodul nach Anspruch 3, dadurch gekennzeichnet, dass das Isolationselement (3) mindestens auf einer Oberfläche eine wannenförmige Vertiefung (30) mit seitlichen Flanken (31) aufweist, in welcher die gewölbte Metallschicht (4) angeordnet ist, wobei sie sich über die seitlichen Flanken (31) erstreckt.

5. Halbleitermodul nach Anspruch 4, dadurch gekennzeichnet, dass eine erste Oberfläche des Isolationselementes (3) eine Vertiefung (30) aufweist und dass eine zweite gegenüberliegende Oberfläche planar ausgebildet ist, wobei beide Oberflächen mit einer Metallschicht (4,5) versehen sind.

6. Halbleitermodul nach Anspruch 4 oder 5, dadurch gekennzeichnet, dass der Abstand d_{Rand} der Ränder der Metallschichten (4,5) ein Vielfaches des Abstandes d_{Mitte} der Mittelzonen der Metallschichten (4,5) beträgt.

7. Halbleitermodul nach Anspruch 1, dadurch gekennzeichnet, dass die Ecken und/oder Kanten der gewölbten Metallschicht (4,5) wulstförmig ausgebildet sind.

8. Halbleitermodul nach Anspruch 7, dadurch gekennzeichnet, dass das Isolationselement (3) eine plane Oberfläche aufweist, welche von Vertiefungen (30) zur Aufnahme der wulstförmigen Ecken und/oder Kanten unterbrochen ist, und dass die gewölbte Metallschicht (4,5) mit Ausnahme der wulstförmigen Ecken oder Kanten auf der planen Oberfläche aufliegt.

9. Halbleitermodul nach Anspruch 7, dadurch gekennzeichnet, dass die Ecken und/oder Kanten einen mindestens annähernd runden Querschnitt aufweisen.

10. Halbleitermodul nach Anspruch 7, dadurch gekennzeichnet, dass die gewölbte Metallschicht (4,5) vollständig in das Isolationselement (3) eingelassen ist, wobei sie mit dem Isolationselement (3) eine gemeinsame plane Oberfläche bildet.
